**Europäisches Patentamt**

**European Patent Office**

**Office européen des brevets**

(19)

(11) Veröffentlichungsnummer : **0 399 325 B1**

(12) **EUROPÄISCHE PATENTSCHRIFT**

(45) Veröffentlichungstag der Patentschrift :
**02.12.92 Patentblatt 92/49**

(51) Int. Cl.$^5$ : **B08B 3/02**

(21) Anmeldenummer : **90109053.0**

(22) Anmeldetag : **14.05.90**

---

(54) **Anordnung zur Behandlung und/oder Reinigung von Gut, insbesondere von mit Bohrungen versehenen Leiterplatten (Fall A).**

---

(30) Priorität : **23.05.89 DE 3916693**

(43) Veröffentlichungstag der Anmeldung :
**28.11.90 Patentblatt 90/48**

(45) Bekanntmachung des Hinweises auf die
Patenterteilung :
**02.12.92 Patentblatt 92/49**

(84) Benannte Vertragsstaaten :
**BE CH DE DK ES FR GB IT LI LU NL SE**

(56) Entgegenhaltungen :
**GB-A- 1 537 924**

(73) Patentinhaber : **SCHERING AKTIENGESELLSCHAFT Berlin und Bergkamen**
**Müllerstrasse 170/178 Postfach 65 03 11**
**W-1000 Berlin 65 (DE)**

(72) Erfinder : **Kallweit, Manfred**
**Ragniter Allee 3a**
**W-1000 Berlin 19 (DE)**
Erfinder : **Bläsing, Horst**
**Strünckweg 1**
**W-1000 Berlin 13 (DE)**

## Beschreibung

Die Erfindung betrifft eine Anordnung gemäß dem Oberbegriff des Anspruches 1. Eine derartige Reinigung oder Behandlung mittels eines Schwallstromes einer entsprechenden Flüssigkeit ist DE-PS 30 11 061 und ferner DE-OS 35 28 575 zu entnehmen. Dabei beschreibt DE-PS 30 11 061 die Zuführung eines Schwallstromes an das Gut von unten, während DE-OS 35 28 575 eine Behandlung entweder nur mit unteren Schwalldüsen, oder aber im Fall von Reinigungsprozessen mit Ultraschall und elektrisch-chemischen Prozessen zwei Schwalldüsen vorsieht, die jeweils versetzt auf der Ober- und Unterseite der Leiterplatte positioniert sind. Die in den beiden zitierten Vorveröffentlichungen beschriebenen Verfahren und Einrichtungen haben sich vom Prinzip her bewährt, werden aber nicht allen Anforderungen in der Praxis gerecht.

Die Aufgabe der Erfindung besteht darin, eine Anordnung gemäß dem Oberbegriff des Anspruches 1 so auszugestalten, daß bestimmte Anwendungsfälle nach diesem Schwallstrom-Prinzip besonders vorteilhaft behandelt werden können, wobei der gerätemäßige Aufwand und auch der Montageaufwand möglichst gering sein sollen.

Die Lösung dieser Aufgabe wird, ausgehend vom Oberbegriff des Anspruches 1, zunächst in den Merkmalen des Kennzeichens des Anspruches 1 gesehen. Hiermit sind all die Anwendungsfälle zu behandeln, bei denen aufgrund der besonderen Gegebenheiten, z.B. besonders geformten oder nur oben liegenden Bohrungen, oder auch sehr kleinen Bohrungsdurchmessern, eine Schwallstrom-Behandlung von oben genügt; u.U. sogar vorteilhafter als eine Schwallstrombehandlung von oben und von unten, bzw. nur von unten ist. Dies gilt insbesondere dann, wenn der Schwallstrom nicht aus Wasser, sondern aus einer Flüssigkeit mit einer Viskosität besteht, die größer als die Viskosität von Wasser ist. Hinzu kommt bei der Erfindung der Vorteil, daß der kontruktive Aufwand und auch die Montagekosten für eine lediglich oberhalb des zu behandelnden Gutes vorzusehenden Schwallstrecke bzw. mehrere, in Transportrichtung des Gutes hintereinander angeordnete Schwallstrecken wesentlich geringer ist als für Schwallstrecken, die sich unterhalb des zu behandelnden Gutes befinden, bzw. für Anordnungen, bei denen sowohl oberhalb als auch unterhalb der Bahn des zu behandelnden Gutes Schwallstrecken vorgesehen sind. Unter einem Schwall wird, wie auch die eingangs zitierte Literatur ausweist, eine kontinuierliche strömende Flüssigkeitssäule oder ein Flüssigkeitsstrang verstanden, der aus der Schwallstrecke austritt und in dieser Schwallform an das zu behandelnde oder zu reinigende Gut gelangt, während im Gegensatz hierzu vorbekannte Spritz- oder Sprühvorrichtungen eine versprühte oder vernebelte Behandlungsflüssigkeit, die also stark mit Luft durchsetzt ist, gegen das zu behandelnde Gut spritzen. Demgegenüber ist der Hauptvorteil eines solchen Schwallstromes, daß er vorhandene Bohrungen intensiv mit der Flüssigkeit durchsetzt und sie somit wesentlich vollständiger reinigt als dies mit einem Versprühen oder Verspritzen einer Flüssigkeit möglich wäre.

Die Merkmale des Anspruches 2 schaffen zusätzlich zu dem Schwallstrom einen Aufstau der Reinigungs- oder Behandlungsflüssigkeit. Hiermit kommt zur kinetischen Energie des Schwallstromes auch noch die Schwerkraft dieses Flüssigkeitsstaues hinzu. Beides ergänzt sich. Von Vorteil ist bei dieser Kombination eines solchen Staus mit einer oberhalb des Behandlungsgutes angeordneten Schwallstrecke, daß die Schwallstrecke im Staubereich einen gewissen Raum einnimmt, so daß weniger an Flüssigkeitsmenge gestaut werden muß, um eine gewisse Höhe des Flüssigkeitsspiegels des Staues zu erreichen. Hierdurch wird die benötigte Pumpenleistung geringer. Mit den vorstehend erläuterten Merkmalen des Anspruches 2 wird der Effekt der Reinigung des zu behandelnden Gutes und insbesondere der Reinigung von Bohrungen verstärkt. Dabei ist insbesondere an Leiterplatten für die Elektronik gedacht, die mit relativ dünnen Bohrungen versehen sind, gegebenenfalls auch nur mit Sackbohrungen, die von oben her wesentlich intensiver gereinigt, d.h. ausgespült werden können als von einer Schwallstrecke, die von unten her an das Behandlungsgut herantritt. Mit dem Aufstau der Flüssigkeit innerhalb der Schwallstrecke wird ferner ein gewisses Reservoir an Flüssigkeit geschaffen, daß dann von Vorteil ist, wenn der Zustrom an Flüssigkeit aus irgendeinem Grunde kurzzeitig verringert oder sogar unterbrochen werden sollte.

Die Merkmale des Anspruches 3 stellen eine konstruktiv einfache und im Betrieb vorteilhafte Ausgestaltung der Staumittel gemäß Anspruch 2 dar. Die Quetschwalzen drehen sich mit dem an ihnen anliegenden und vorbeigeführten Behandlungsgut, so daß eine schädliche Reibung zwischen Staumittel und Behandlungsgut vermieden ist.

Die Merkmale des Anspruches 4 bewirken, daß über die gesamte Breite des zu behandelnden Gutes eine gleichmäßige Verteilung und auch in etwa gleichmäßiger Ausströmquerschnitt des Flüssigkeitsschwalles gegeben ist. Eine solche Anordnung ist zwar für sich aus DE-OS 35 28 575 bekannt, jedoch nicht in Verbindung mit einer Anordnung gemäß einem oder mehreren der vorstehend erläuterten Ansprüche.

Anspruch 5 ist eine vorteilhafte Weiterbildung von Anspruch 4.

Weitere Vorteile und Merkmale der Erfindung sind der nachstehenden Beschreibung und der zugehörigen, im wesentlichen schematischen Zeichnung zu entnehmen. In der Zeichnung zeigt:

Fig. 1: eine erste Ausführungsform der Erfindung in einem Schnitt gemäß der Linie I-I in Fig. 3,

Fig. 2: eine zweite Ausführungsform der Erfindung in einem Schnitt gemäß der Linie II-II in Fig. 3,

Fig. 3: eine Draufsicht auf eine Anordnung nach der Erfindung, wobei in der in der Zeichnung linken Hälfte die Ausführungsform nach Fig. 1 und in der in der Zeichnung rechten Hälfte die Ausführungsform nach Fig. 2 schematisch dargestellt ist.

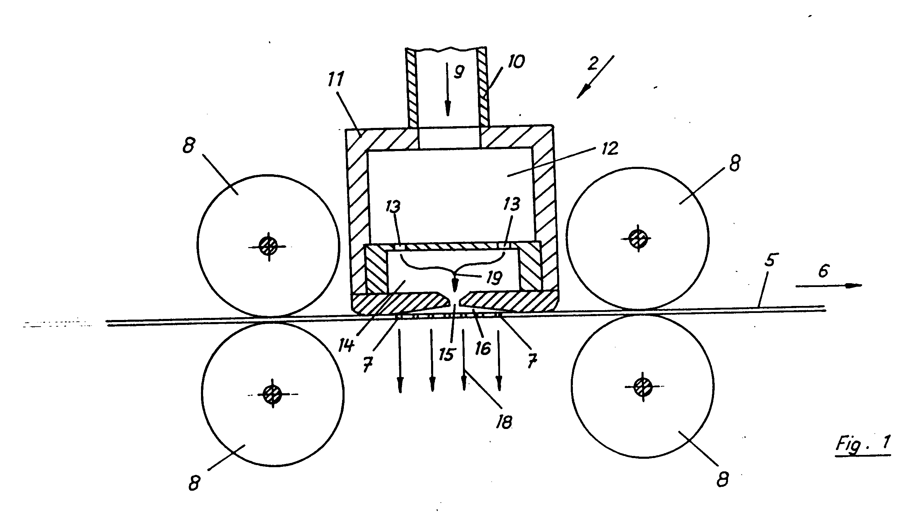

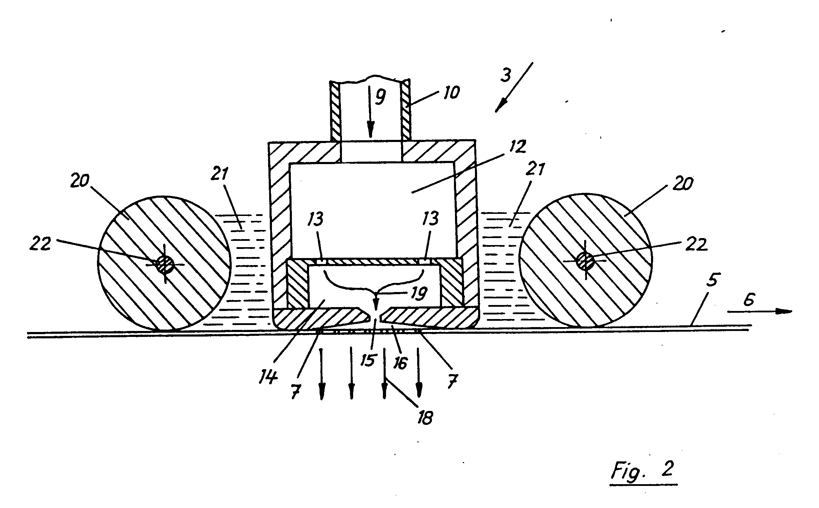

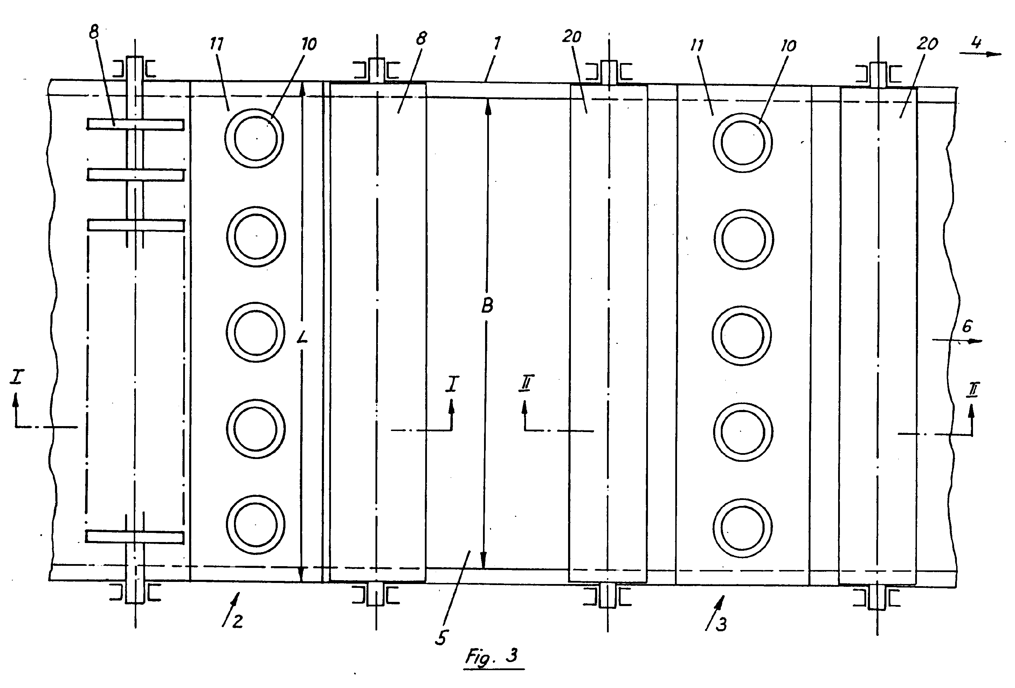

Fig. 3 zeigt in der Draufsicht schematisch einen Teil 1 einer Anlage zum chemischen Behandeln und-/oder Reinigen von plattenförmigen Gegenständen mit mehreren Schwallstrecken 2, 3, die in Pfeilrichtung 4 in der gewünschten Anzahl hintereinander angeordnet sind. Die zu behandelnden Platten 5, insbesondere Leiterplatten für elektronische Zwecke, werden in Pfeilrichtung 6 transportiert. Dabei sind der zeichnerischen Vereinfachung wegen eine Schwallstrecke 2 in der Ausführung gemäß Fig. 1 und eine Schwallstrecke 3 in der Ausführung gemäß Fig. 2 in Transportrichtung 6 des Gutes hintereinander dargestellt. Es versteht sich, daß die Erfindung in der Regel mit hintereinander angeordneten Schwallstrecken nur der gleichen Ausführung (Fig. 1 oder Fig. 2) verwirklicht werden wird.

Das Ausführungsbeispiel der Fig. 1 zeigt die o.g. Schwallstrecke 2, wobei das Gut 5 von der schmalen Seitenkante her gesehen ist. Es weist Bohrungen 7 auf, die aus Gründen der zeichnerischen Vereinfachung nur im Bereich der Schwallstrecke gezeichnet sind. Mittels auf einer gemeinsamen Welle angeordneten, scheibenartigen Transportwalzen 8 wird das Gut 5 in der Richtung 6 transportiert.

Die Flüssigkeit, z.B. reines Wasser, wird in nicht näher dargestellter Weise gemäß dem Pfeil 9 über eine Reihe von Anschlußleitungen oder Zuführungen 10 größeren Durchmessers im Gehäuse 11 der Schwallstrecke einem Vorraum 12 zugeleitet, der sich praktisch über die gesamte Länge L des Gehäuses der Schwallstrecke erstreckt.Damit wird die gesamte Breite B des Gutes 5 behandelt. Von dort gelangt die Flüssigkeit über zwei oder mehrere Reihen von Bohrungen 13 kleineren Durchmessers (bezogen auf den Durchmesser der Leitungen 10) in eine Verteilerraum 14. Die Bohrungen 13 sind dabei ebenfalls über die Länge L verteilt hintereinander vorgesehen. Die Anzahl Bohrungen 13 kleineren Durchmessers wirkt wie eine Lochmaske. Beim Übergang der Flüssigkeit von dem Vorraum 12 in den Verteilerraum 14 erfolgt ein gewisser Druckabfall der Flüssigkeit und gleichzeitig über die Lochmaske eine gleichmäßige Verteilung der Flüssigkeit innerhalb des Verteilerraumes 14 über die gesamte Länge L. Somit tritt aus der schlitzförmigen, sich ebenfalls über die gesamte Länge L erstreckenden Schwallöffnung 15 die Flüssigkeit in einem gleichmäßigen Schwall mit der diesem Schwall innewohnenden kinetischen Energie aus und verteilt sich in den Schwallraum 16, um von dort durch die Bohrungen 17 des Gutes und dann gemäß den Pfeilen 18 nach unten wegzufließen. Es empfiehlt sich, daß in Transportrichtung 6 des Gutes betrachtet die Bohrungen 13 sowohl zu den Leitungen 10, als auch zum Schlitz 16 versetzt angeordnet sind. Damit kann der Flüssigkeitsstrom 9 nicht direkt durch die Bohrungen 13 in den Verteilerraum 14 gelangen und ferner kann der Strom durch die Bohrungen 13 nicht unmittelbar, d.h. in gerader Linie auf den Schlitz 16 treffen. Eine Reinigungs- oder Behandlungsflüssigkeit kann neben reinem Wasser auch eine Säure, wie eine Schwefelsäure, oder eine Base sein. Bei einer Reinigung werden Rückstände auch aus Bohrungen 7 von sehr kleinem Durchmesser, von z.B. 0, 1 mm, einwandfrei herausgespült. Insbesondere ist der Spüleffekt der Anordnung nach der Erfindung dann gegeben, wenn statt der gezeichneten durchgehenden Bohrungen 7 das Gut Sackbohrungen aufweist, deren Öffnung nach oben gerichtet ist. Auch dann kann der Schwallstrom Rückstände aus solchen Sacklöchern herausspülen.

Die dargestellte Ausführung der Schwallstrecke 2 mit Vorraum 12 und Verteilerraum 14 ist die bevorzugte Ausführungsform der Erfindung. Das Prinzip der Erfindung, nämlich Aufbringung eines Schwallstromes von oben her auf das zu behandelnde bzw. zu reinigende Gut und Bildung eines Stauraumes 16 oberhalb des Gutes kann aber auch ohne die Anordnung aus Vorraum und Verteilerraum verwirklicht werden, indem die Behandlungs- oder Reinigungsflüssigkeit unmittelbar gemäß Pfeil 19 zugeführt wird, bevorzugt in ein anstelle des Verteilerraumes 14 vorgesehenes Gehäuse. Auch an dieser Stelle sei vermerkt, daß mit der Erfindung sowohl eine Reinigungs- oder Waschflüssigkeit (bevorzugt Wasser), aber auch eine Behandlungsflüssigkeit (z.B. eine Säure) im Schwallstrom auf das Gut gebracht werden kann.

Die vorgenannten Alternativen sind auch beim Ausführungsbeispiel der Fig. 2 zu verwirklichen, in dem mit dem Beispiel der Fig. 1 gleiche Bauteile auch gleich beziffert sind. Die Darstellung von Transportwalzen ist jedoch aus zeichnerischen Gründen weggelassen. Sie könnten aber ebenfalls vorhanden sein. Dieses Ausführungsbeispiel zeigt die Verwendung von sogenannten Quetschwalzen 20 als Staumittel um innerhalb der strichlierten, zwickelartigen Stauräume 21 die jeweilige Flüssigkeit sich aufstauen zu lassen. Dadurch wird die Strecke, über welche die Behandlungsflüssigkeit auf das Gut einwirken kann, verlängert. Dies ist vorteilhaft, auch wenn die intensivste Einwirkung erst im Schwallraum 16 eintritt.

Die dem vorgenannten Aufstauen dienenden Quetschwalzen 20 erstrecken sich über die gesamte Länge L. Sie sind um ihre Achsen 22 drehbar und liegen auf dem Behandlungsgut 5 auf, so daß sie hiervon mitgedreht werden und eine schädliche Reibung zwischen der Oberfläche der Quetschwalzen 20 und der Oberfläche des Gutes 5 vermieden wird, die besonders empfindliches Gut (z.B. elektronische Leiterplatten) beschädigen könnte.

Alle dargestellten und beschriebenen Merkmale, sowie ihre Kombinationen, sind erfindungswesentlich.

**Patentansprüche**

1. Anordnung zur Behandlung und/oder Reinigung von Gut, insbesondere von mit Bohrungen versehenen Leiterplatten, mit Hilfe einer im Schwall herangeführten Flüssigkeit, dadurch gekennzeichnet, daß die Schwallstrecke bzw. Schwallstrecken (2, 3) lediglich oberhalb der Bahn des Gutes (5) vorgesehen ist bzw. sind.

2. Anordnung nach Anspruch 1, dadurch gekennzeichnet, daß in Transportrichtung (6) des Gutes (5) betrachtet am Eingang und Ausgang jeder Schwallstrecke ein auf dem Gut aufliegendes Staumittel vorgesehen ist derart, daß zwischen den beiden Staumitteln und der Schwallstrecke ein aufgetautes Flüssigkeitsbett (21) entsteht.

3. Anordnung nach Anspruch 2, dadurch gekennzeichnet, daß als Staumittel Quetschwalzen (20) vorgesehen sind.

4. Anordnung nach einem der Ansprüche 1 bis 3, dadurch gekennzeichnet, daß die Schwallstrecke einen Vorraum (12) mit Zuführöffnungen oder -leitungen (10) größeren Durchmessers, eine sich in Strömungsrichtung der Flüssigkeit daran anschließende Lochmaske mit Bohrungen (13) kleineren Durchmessers und einen sich in Strömungsrichtung daran anschließenden Verteilerraum (14) aufweist, der in Strömungsrichtung der Flüssigkeit einen Austrittsschlitz (15) aufweist, der zu einem Schwallraum (16) führt, wobei die Leitungsreihe (10), der Vorraum (12), die Bohrungen (13), der Verteilerraum (14), der Austrittsschlitz (15) und der Schwallraum (16) sich im wesentlichen über die gesamte Länge (L) der Schwallstrecke (2) erstrecken.

5. Anordnung nach Anspruch 4, dadurch gekennzeichnet, daß die Bohrungen (13) kleineren Durchmessers in Transportrichtung (6) des Gutes betrachtet sowohl zu den Zuführleitungen (10) größeren Durchmessers, als auch zum Austrittsschlitz (15) versetzt angeordnet sind.

6. Anordnung nach einem der Ansprüche 1 bis 3, dadurch gekennzeichnet, daß, insbesondere bei kürzeren Schwallstrecken, die Anzahl der Zuführungsleitungen (10), sowie die Größe deren gesamten Querschnittsflächen gegenüber der Querschnittsfläche des Austrittsschlitzes (15) so groß gewählt ist, daß der überwiegende Druckabfall erst am Austrittsschlitz (15) eintritt, so daß zur Erzielung einer ausreichenden Gleichmäßigkeit der Verteilung der Flüssigkeit im Austrittsschlitz (15) auf die Lochmaske mit den Bohrungen (13) und den Verteilerraum (14) verzichtet werden kann.

**Claims**

1. A system for processing and/or cleaning articles, in particular circuit boards incorporating drillings or drilled holes, with the aid of a liquid that is applied in a surge, wherein the surge section or sections is/are provided only above the path of the articles.

2. A system as claimed in claim 1, wherein, viewed in the direction of movement of the articles, at the entry and exit of each surge section there is an accumulator device arranged so as to lie upon the articles such that between the two accumulator means and the surge section there is an accumulated bed of liquid.

3. A system as claimed in claim 2, wherein said accumulator devices comprise squeeze rollers.

4. A system as claimed in claim 1, wherein the surge section incorporates a pre-chamber with access openings or feedlines of a greater diameter, a perforated mask with drillings of smaller diameter that is adjacent thereto in the direction of flow of the liquid, and a distributor chamber that is adjacent thereto in the direction of flow of the liquid, said distributor chamber incorporating an outlet slot in the direction of flow of the liquid, said slot leading to a surge chamber, the series of feedlines, the pre-chamber, the drillings, the distributor chamber, the outlet slot and the surge chamber extending substantially to the whole length of the surge section.

5. A system as claimed in claim 4, wherein the drillings of smaller diameter are displaced in the direction of movement of the articles, both relative to the feedlines of greater diameter and to the outlet slot.

6. A system as claimed in any one of the claims 1 to 3, wherein, in particular in the case of shorter surge sections, the number of feedlines, as well as the size of their total cross-sectional area, is selected to be so large relative to the cross-section area of the outlet slot, that the predominant pressure drop occurs first at the outlet slot, so that in order to achieve adequate equality of the distribution of the liquid within the outlet slot it is possible to dispense with the perforated mask with the drillings and the distributor chamber.

## Revendications

1. Dispositif pour le traitement et/ou le nettoyage d'articles, et en particulier de cartes imprimées dotées de forures, au moyen d'un liquide projeté à la lance, caractérisé en ce que la ou les lignes de projection (2,3) est ou sont prévues uniquement au-dessus de la trajectoire des articles (5).

2. Dispositif selon la revendication 1, caractérisé en ce que, vu dans la direction de transport (6) des articles (5), au début et à la fin de chaque lignes de projection des moyens de retenue couchés sur les articles sont prévus de manière à ce qu'un lit de liquide refoulé (21) se forme entre les deux moyens de retenue sur la ligne de projection.

3. Dispositif selon la revendication 2, caractérisé en ce que des rouleaux exprimeurs (20) sont prévus comme moyens de retenue.

4. Dispositif selon l'une des revendications 1 à 3, caractérisé en ce que la ligne de projection présente une avant-chambre (12) avec ouvertures ou conduites d'amenée (10) d'un diamètre assez important, un masque à trous (13) d'un diamètre assez petit directement adjacent dans la direction d'écoulement du liquide, et une chambre de distribution (14) directement adjacente dans la direction d'écoulement, qui présente une fente de sortie (15) dans la direction d'écoulement du liquide, conduisant à une chambre de projection (16), la rangée de conduites (10), l'avant-chambre (12), les trous (13), la chambre de distribution (14), la fente de sortie (15) et la chambre de projection (16) s'étendant essentiellement sur la longueur totale (L) de la ligne de projection (2).

5. Dispositif selon la revendication 4, caractérisé en ce que les trous (13) d'un diamètre assez petit, vu dans la direction de transport (6) des articles, sont désaxées aussi bien par rapport aux conduites d'amenée (10) d'un diamètre assez important que par rapport à la fente de sortie (15).

6. Dispositif selon l'une des revendications 1 à 3, caractérisé en ce que, en particulier pour les lignes de projection assez courtes, le nombre de conduites d'amenée (10) ainsi que la grandeur de leurs superficies totales en coupe transversale par rapport à la superficie totale de la fente de sortie (15) est dimensionnée de façon suffisamment importante de manière à ce que la principale chute de pression se produise seulement au niveau de la fente de sortie (15), de sorte que pour obtenir une régularité suffisante de la répartition du liquide dans la fente de sortie (15), il est possible de renoncer au masque à trous (13) et à la chambre de distribution (14).

Fig. 1

Fig. 2

*Fig. 3*

EP 0 399 325 B1